# EUROPEAN PATENT SPECIFICATION

(11) **EP 2 221 877 B1**
(45) Date of publication and mention of the grant of the patent: **23.01.2019**
(21) Application number: 09174024.1
(22) Date of filing: 26.10.2009
(51) Int. Cl.: H01L 31/0352, H01L 31/075, H01L 31/18

(54) **Solar cell including silicon nano wire and method for fabricating solar cell**
Solarzelle mit Siliziumnanodraht und Herstellungsverfahren für die Solarzelle
Cellule solaire incluant des nanofils en silicone et procédé de fabrication de la cellule solaire

(30) Priority: 18.02.2009 KR 20090013459; 18.02.2009 KR 20090013465; 23.10.2009 KR 20090101154
(43) Date of publication of application: 25.08.2010
(73) Proprietor: Korea Institute Of Industrial Technology, Chungcheongnam-do (KR)
(72) Inventor: Jeong, Chaehwan, Gwangsan-gu, Gwangju (KR); Jeon, Minsung, Mabuk-dong Giheong-Gu, Yongin-si (KR); Kim, Jin Hyeok, Munheung2(i)-dong,Buk-gu,Gwangju (KR); Ko, Hang Ju, Buk-gu,Gwangju (KR); Lee, Suk Ho, Buk-gu Gwangju (KR)
(74) Representative: Hirsch & Associés

(56) References cited:
- EP-A1- 1 946 833
- EP-A2- 1 892 769
- US-A1- 2006 207 647
- US-A1- 2007 178 709
- US-A1- 2008 006 319
- US-A1- 2008 047 604
- US-A1- 2008 169 017

## Description

### CROSS-REFERENCE TO RELATED APPLICATION

This application claims priority to and the benefit of Korean Patent Application Nos. 10-2009-0013458, filed on February 18, 2009, 10-2009-0013465, filed on February 18, 2009, and 10-2009-0101154, filed on October 23, 2009, the entire content of which is incorporated herein by reference.

### BACKGROUND OF THE INVENTION

### 1. Field of the Invention

The present invention relates to a method for fabricating a silicon nano wire, a solar cell including the silicon nano wire and a method for fabricating the solar cell.

### 2. Related Art

As obligations to reduce greenhouse gas emission are currently accelerating under the Climate Change Convention, carbon dioxide market is booming. Accordingly, new renewable energy fields are drawing greater attention. A solar cell, a representative example of the new recyclable energy fields, directly converts sunlight, which is a limitless source of clean energy, into electricity using the photoelectric effect.

Nearly 90% of the current solar cell market is dominated by silicon (Si) wafer based solar cells and the solar cell market is considerably influenced by the supply of Si material used in producing Si wafers. Thus, due to the complexity of a high-temperature process as well as the supply shortage of Si material, technology of fabricating miniaturized, thin film solar cells by a low-temperature process is unlikely achievable.

Patent publication documents EP1892769 and US2008/0006319 both describe solar cells with doped silicon nanostructures.

### SUMMARY OF THE INVENTION

In view of the above problems, it is an object of the present invention to provide a solar cell comprising silicon nano wires as defined by the subject-matter of claim 1, and a method for manufacturing a solar cell comprising silicon nano wires as defined by the subject-matter of claim 4.

In one embodiment of the present invention, the solar cell may further include a transparent conductive oxide (TCO) layer provided on the second-type doping layer, an antireflective layer formed on the TCO layer to expose predetermined regions of the TCO layers, and a front electrodes patterned on the predetermined regions of the exposed TCO layer.

In another embodiment of the present invention, the solar cell may further include a transparent conductive oxide (TCO) layer provided between the substrate and the first++-type poly-Si layer, and a rear electrode formed on the second-type doping layer.

In another embodiment of the present invention, the intrinsic layer may be a top-cell intrinsic layer, the second-type doping layer may be a top-cell second-type doping layer, and the solar cell may further include a buffer layer formed on the top-cell second-type doping layer, a bottom-cell first-type doping layer formed on the buffer layer, a bottom-cell intrinsic layer formed on the bottom-cell first-type doping layer, a bottom-cell second-type doping layer formed on the bottom-cell intrinsic layer, and a rear electrode formed on the bottom-cell second-type doping layer.

In an embodiment of the present invention, before the forming of the first++-type poly-Si layer, the method may further include forming a TCO layer on the substrate, and after the growing of the first-type Si nano wires, and may further include forming an intrinsic layer on the substrate having the first-type Si nano wires grown thereon, forming a second-type doping layer on the intrinsic layer, and forming a rear electrode.

In another embodiment of the present invention, before the forming of the first++-type poly-Si layer, the method may further include forming a TCO layer on the substrate, and after the growing of the first-type Si nano wires, and may further include forming a top-cell intrinsic layer on the substrate having the first-type Si nano wires grown thereon, forming a top-cell second-type doping layer on the top-cell intrinsic layer, forming a buffer layer on the top-cell second-type doping layer, forming a bottom-cell first-type doping layer on the buffer layer, forming a bottom-cell intrinsic layer on the bottom-cell first-type doping layer, forming a bottom-cell second-type doping layer on the bottom-cell intrinsic layer, and forming a rear electrode.

In another embodiment of the present invention, the forming of the metal film layer may include forming the metal film layer using a sputtering method or evaporation method to a thickness in a range of about 100 to about 150 nm.

According to another embodiment of the present invention, in the forming of the metal film layer, at least one selected from the group consisting of Au, In, Ga and Sn may be used.

According to another embodiment of the present invention, in the forming of the metal film layer or the growing of the first-type Si nano wires, inductively coupled plasma chemical vapor deposition or very high frequency-chemical vapor deposition may be used.

In another embodiment of the present invention, the forming of the metal film layer and the growing of the first-type Si nano wires may be performed in sequence using inductively coupled plasma chemical vapor deposition or very high frequency-chemical vapor deposition.

In another embodiment of the present invention, the forming of the metal film layer may include forming the metal film layer from metal nano particles using inductively coupled plasma chemical vapor deposition under processing conditions including a substrate temperature from about 200 to about 400°C, a working pressure ranging from about 80 to about 150 mTorr, a hydrogen (H₂) gas flow rate ranging from about 100 to about 300 sccm, plasma power ranging from about 500 to about 700 W, susceptor power ranging from about 30 to about 50 W, and a processing time ranging from about 30 to about 90 minutes.

In another embodiment of the present invention, the forming of the metal film layer may include forming the metal film layer from metal nano particles using very high frequency-chemical vapor deposition under processing conditions including a substrate temperature from about 200 to about 400°C, a working pressure ranging from about 0.05 to about 0.02 Torr, plasma power ranging from about 40 to about 60 W, and a processing time ranging from about 30 to about 60 minutes.

In another embodiment of the present invention, the growing of the first-type Si nano wires may include allowing the first-type Si nano wires to grow using inductively coupled plasma chemical vapor deposition under processing conditions including a substrate temperature from about 200 to about 400°C, a working pressure ranging from about 70 to about 80 mTorr, a silane (SiH₄) gas ratio of 0.1 to 0.2, plasma power ranging from about 500 to about 700 W, susceptor power ranging from about 30 to about 50 W, and a processing time ranging from about 1 to about 20 minutes, wherein the silane gas ratio corresponds a ratio of silane gas relative to the mixed gas containing silane and hydrogen gases.

In another embodiment of the present invention, the growing of the first-type Si nano wires may include allowing the first-type Si nano wires to grow using very high frequency-chemical vapor deposition under processing conditions including a substrate temperature from about 200 to about 400°C, a working pressure ranging from about 0.05 to about 0.02 Torr, a silane (SiH₄) gas ratio of 0.4 to 0.6, plasma power ranging from about 40 to about 60 W, and a processing time ranging from about 30 to about 60 minutes.

In another embodiment of the present invention, after the growing of the first-type Si nano wires, the method may further include removing residual metals from the substrate.

According to the present invention, the above and other objects and advantages may be realized.

### BRIEF DESCRIPTION OF THE DRAWINGS

The present invention will become more fully understood from the detailed description given herein below for illustration only, which thus is not limitative of the present invention, and wherein:
FIG. 1 is a sectional view illustrating a solar cell according to an embodiment of the present invention,
FIG. 2 is a sectional view illustrating a solar cell according to another embodiment of the present invention,
FIG. 3 is a sectional view illustrating a solar cell according to still another embodiment of the present invention,
FIG. 4 is a flowchart illustrating a method for fabricating a first-type silicon nano wire according to an embodiment of the present invention,
FIG. 5 is a flowchart illustrating a sequential process of a method for fabricating a solar cell according to an embodiment of the present invention,
FIG. 6 FIG. 5 is a flowchart illustrating a sequential process of a method for fabricating a solar cell according to another embodiment of the present invention, and
FIG. 7 is a flowchart illustrating a sequential process of a method for fabricating a solar cell according to still another embodiment of the present invention.

### DETAILED DESCRIPTION OF THE INVENTION

Hereinafter, embodiments of the present invention will be described in detail with reference to the accompanying drawings.

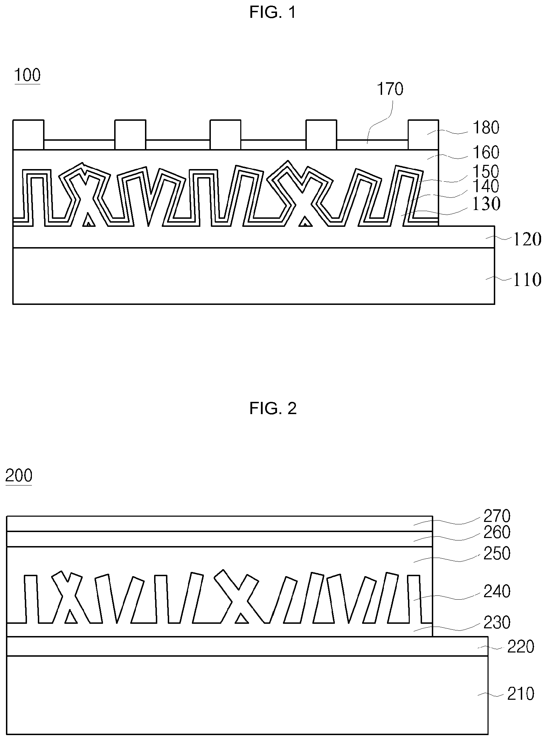

FIG. 1 is a sectional view illustrating a solar cell according to an embodiment of the present invention.

Referring to FIG. 1, the solar cell 100 according to an embodiment of the present invention includes a substrate 110, a first++-type poly-Si layer 120, a first-type silicon nano wire layer 130, an intrinsic layer 140, a second-type doping layer 150, a TCO (Transparent Conducting Oxide) layer 160, an antireflective layer 170, and a front electrode 180.

Here, the first type is a P type, and the second type is an N type. On the other hand, the first type may be an N type, and the second type is a P type.

Meanwhile, the first-type or second-type labeling with marks "++" signifies impurity doping level. The first or second type with a "+" mark means a type doped with higher impurity level than that without "+" mark. Similarly, the first or second type with a "++" mark means a type doped with more impurities than that without "+" mark.

The substrate 110 may be a transparent insulating substrate capable of transmitting sunlight or an opaque substrate such as a metal foil.

When the substrate 110 is a transparent insulating substrate, it may be a glass substrate or a plastic substrate.

When the substrate 110 is a metal foil, an insulating layer may be provided between the substrate 110 between the first++-type poly-Si layer 120 for insulating the substrate 110 from the first++-type poly-Si layer 120.

The first++-type poly-Si layer 120 may be provided at one surface of the substrate 110.

The first++-type poly-Si layer 120 is a first type poly-Si layer with a relatively high doping level, serving as a rear electrode.

In addition, the first++-type poly-Si layer 120 may serve as a seed layer that allows a first-type silicon nano wires of the first-type silicon nano wire layer 130 to grow.

The first-type silicon nano wire layer 130 may include first-type Si nano wires grown on predetermined regions of the first++-type poly-Si layer 120. That is to say, the first-type silicon nano wire layer 130 may be formed of first-type Si nano wires grown on predetermined regions of the first++-type poly-Si layer 120 using metal induced crystallization method or laser crystallization method.

In the first-type silicon nano wire layer 130, each of the first-type silicon nano wires may have a length in a range of about 2 to about 5 µm and a diameter in a range of about 1 to about 5 nm. When the sunlight is incident, the first-type silicon nano wires of the first-type silicon nano wire layer 130 function to absorb the light. That is to say, when the first-type silicon nano wires have a length in a range of about 2 to about 5 µm and a diameter in a range of about 1 to about 5 nm, the absorption efficiency of the first-type silicon nano wires is highest.

The intrinsic layer 140 is provided on the first-type silicon nano wire layer 240 and on a surface of the first++-type poly-Si layer 120 without first-type silicon nano wires grown thereon, that is, on the substrate 110 having the first-type silicon nano wire layer 130.

The intrinsic layer 140 may be made of intrinsic silicon undoped with first- or second-type impurity.

The intrinsic layer 140 may be made of a variety of intrinsic silicon layers, preferably, a hydrogenated amorphous silicon layer, that is, an α-Sigh layer.

The intrinsic layer 140 may serve to passivate the first-type silicon nano wire layer 130.

The intrinsic layer 140 may be formed by chemical vapor deposition or physical vapor deposition.

When the intrinsic layer 140 is formed by CVD, mixed gas containing hydrogen (H₂) gas and silane (SiH₄) gas is used. In this case, the mixed gas has a hydrogen-to-silane (H₂/SiH₄) ratio of 8 to10 and a working pressure ranges from about 70 to about 90 mTorr, and processing power ranges from about 200 to about 300 W, and a processing temperature ranges from about 250 to about 350°C.

When the intrinsic layer 140 is formed by PVD, noticeable improvement is attained in an interfacial characteristic between the intrinsic layer 140 and a layer contacting the intrinsic layer 140 particularly the first-type silicon nano wire layer 130.

The second-type doping layer 150 is provided on the intrinsic layer 140.

The second-type doping layer 150 may be a second type doped Si layer.

The second-type doping layer 150 may be a second+-type doping layer or a second-type doping layer, which is a layer with a lower impurity level.

The second-type doping layer 150 may be formed by PVD or CVD, such as PECVD.

The TCO layer 160 is formed on the second-type doping layer 150.

The TCO layer 160 may be a TCO (Transparent Conducting Oxide) such as ZnO (Zinc Oxide), AZO (Aluminum Zinc Oxide), ITO (Indium Tin Oxide), SnO₂:F, and so on.

The TCO layer 160 may have a thickness of 5 *µ*m or greater and may be formed using PVD such as sputtering or CVD such as MOCVD.

The antireflective layer 170 may be formed on the TCO layer 160 to expose predetermined regions of the TCO layer 160.

The antireflective layer 170 is configured to prevent incident sunlight from being reflected and emitted outside, thereby increasing the conversion efficiency.

The antireflective layer 170 may be formed of silicon nitride (SiN).

The front electrode 180 is provided to contact the TCO layer 160 on the predetermined regions of the TCO layer 160 exposed by the antireflective layer 170.

The front electrode 180 may be made of a conductive material such as Al or Ag.

The front electrode 180 may have a thickness of about 0.2 to about 1 µm, preferably about 0.5 µm.

The front electrode 180 may be provided in patterned formats.

FIG. 2 is a sectional view illustrating a solar cell according to another embodiment of the present invention.

Referring to FIG. 2, the solar cell 200 according to another embodiment of the present invention may include a substrate 210, a TCO layer 220, a first++-type poly-Si layer 230, a first-type silicon nano wire layer 240, an intrinsic layer 250, a second-type doping layer 260, and a rear electrode 270.

The substrate 210 may be a transparent insulating substrate capable of transmitting sunlight.

Alternatively, the substrate 210 may be a glass substrate or a plastic substrate.

The TCO layer 220 is formed on one surface of the substrate 210.

The TCO layer 220 may be a TCO (Transparent Conducting Oxide) such as ZnO (Zinc Oxide), AZO (Aluminum Zinc Oxide), ITO (Indium Tin Oxide), SnO₂:F, and so on.

The TCO layer 220 may be formed using PVD such as sputtering or CVD such as MOCVD.

The first++-type poly-Si layer 230 may be formed on the TCO layer 220.

The first++-type poly-Si layer 230 is a first type poly-Si layer with a relatively high doping level, serving as a rear electrode.

In addition, the first type poly-Si layer 230 may serve as a seed layer that allows first-type silicon nano wires of the first-type silicon nano wire layer 240 to grow.

The first-type silicon nano wire layer 240 may include first-type Si nano wires grown on predetermined regions of the first++-type poly-Si layer 230. That is to say, the first-type silicon nano wire layer 240 may be formed of first-type Si nano wires grown on predetermined regions of the first++-type poly-Si layer 230 using a metal induced crystallization method or a laser crystallization method.

In the first-type silicon nano wire layer 240, each of the first-type silicon nano wires may have a length in a range of about 2 to about 5 µm and a diameter in a range of about 1 to about 5 nm. When the sunlight is incident, the first-type silicon nano wires of the first-type silicon nano wire layer 240 function to absorb the light. That is to say, when the first-type silicon nano wires have a length in a range of about 2 to about 5 µm and a diameter in a range of about 1 to about 5 nm, the absorption efficiency of the first-type silicon nano wires is highest.

The intrinsic layer 250 is provided on the first-type silicon nano wire layer 240 and on a surface of the first-type Si layer 230 without first-type silicon nano wires grown thereon.

The intrinsic layer 250 may be made of intrinsic silicon undoped with first- or second-type impurity.

The intrinsic layer 250 may be made of a variety of intrinsic silicon layers, preferably, a hydrogenated amorphous silicon layer, that is, an α-Si:H layer.

The intrinsic layer 250 may serve to passivate the first-type silicon nano wire layer 240.

The intrinsic layer 250 may be formed by chemical vapor deposition or physical vapor deposition, preferably inductively coupled plasma (ICP)-CVD.

When the intrinsic layer 250 is formed by ICP-CVD, mixed gas containing hydrogen (H₂) gas and silane (SiH₄) gas is preferably used. In this case, the mixed gas may have a hydrogen-to-silane (H₂/SiH₄) ratio of 8 to10 and a working pressure may range from about 70 to about 90 mTorr, and processing power may range from about 200 to about 300 W, and a processing temperature may range from about 250 to about 350°C.

When the intrinsic layer 250 is formed by ICP-CVD, noticeable improvement is attained in an interfacial characteristic between the intrinsic layer 250 and a layer contacting the intrinsic layer 250, particularly the first-type silicon nano wire layer 240.

The second-type doping layer 260 is provided on the intrinsic layer 250.

The second-type doping layer 260 may be a second type doped Si layer.

The second-type doping layer 260 may be a second+-type doping layer or a second-type doping layer, which is a layer with a lower impurity level.

The second-type doping layer 260 may be formed by PVD or CVD, such as PECVD.

The second-type doping layer 260 may have a thickness of about 10 to about 15 nm, preferably about 12 nm.

The rear electrode 270 is provided on the second-type doping layer 260.

The rear electrode 270 may be made of a conductive material such as Al or Ag.

The rear electrode 270 may be provided on an entire surface of the second-type doping layer 260.

The rear electrode 270 may serve as an antireflective layer that prevents incident sunlight from being reflected and emitted outside, thereby increasing the conversion efficiency.

When the rear electrode 270 is made of Al, it may have a thickness of about 200 to about 400 nm, preferably about 300 nm.

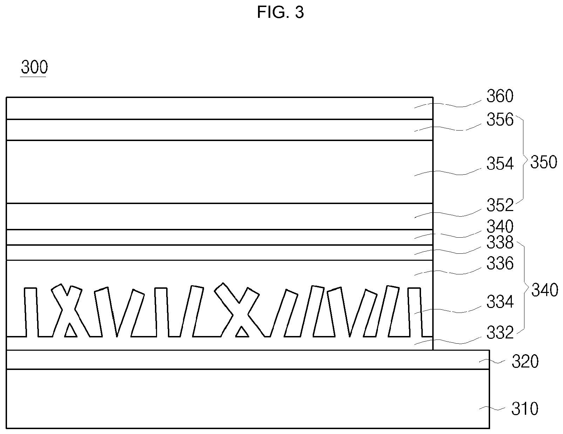

FIG. 3 is a sectional view illustrating a solar cell according to still another embodiment of the present invention.

Referring to FIG. 3, the solar cell 300 according to another embodiment of the present invention may include a substrate 310, a TCO layer 320, a top cell 330, a buffer layer 340, a bottom cell 350 and a rear electrode 360.

The top cell 330 includes a first++-type poly-Si layer 332, a first-type silicon nano wire layer 334, a top-cell intrinsic layer 336 and a top-cell second-type doping layer 338.

The bottom cell 350 includes a bottom-cell first-type doping layer 352, a bottom-cell first-type intrinsic layer 354 and a bottom-cell second-type doping layer 356.

The substrate 310 may be a transparent insulating substrate capable of transmitting sunlight.

Alternatively, the substrate 310 may be a glass substrate or a plastic substrate.

The TCO layer 320 is formed on one surface of the substrate 310.

The TCO layer 320 may be a TCO (Transparent Conducting Oxide) such as ZnO (Zinc Oxide), AZO (Aluminum Zinc Oxide), ITO (Indium Tin Oxide), SnO₂:F, and so on.

The first++-type poly-Si layer 332 may be formed on the TCO layer 320.

The first++-type poly-Si layer 332 is a first type poly-Si layer with a relatively high doping level.

In addition, the first type poly-Si layer 332 may serve as a seed layer that allows first-type silicon nano wires of the first-type silicon nano wire layer 334 to grow.

The first-type silicon nano wire layer 334 may include first-type Si nano wires grown on predetermined regions of the first++-type poly-Si layer 332. That is to say, the first-type silicon nano wire layer 334 may be formed of first-type Si nano wires grown on predetermined regions of the first++-type poly-Si layer 332 using a metal induced crystallization method or a laser crystallization method.

In the first-type silicon nano wire layer 334, each of the first-type silicon nano wires may have a length in a range of about 2 to about 5 *µ*m and a diameter in a range of about 1 to about 5 nm. When the sunlight is incident, the first-type silicon nano wires of the first-type silicon nano wire layer 334 function to absorb the light. That is to say, when the first-type silicon nano wires have a length in a range of about 2 to about 5 µm and a diameter in a range of about 1 to about 5 nm, the absorption efficiency of the first-type silicon nano wires is highest.

The top-cell intrinsic layer 336 is provided on the first-type silicon nano wire layer 334 and on a surface of the first++-type Si layer 332 without first-type silicon nano wires grown thereon.

The top-cell intrinsic layer 336 may be made of intrinsic silicon undoped with first- or second-type impurity.

The top-cell intrinsic layer 336 may be made of a variety of intrinsic silicon layers, preferably, a hydrogenated amorphous silicon layer, that is, an α-Si:H layer.

Here, the top-cell intrinsic layer 336 may have the same configuration as that labeled 250 shown in FIG. 2.

The top-cell intrinsic layer 336 may serve to passivate the first-type silicon nano wire layer 334.

The top-cell intrinsic layer 336 may be formed by chemical vapor deposition or physical vapor deposition, preferably inductively coupled plasma (ICP)-CVD.

When the top-cell intrinsic layer 336 is formed by ICP-CVD, mixed gas containing hydrogen (H₂) gas and silane (SiH₄) gas is preferably used. In this case, the mixed gas may have a hydrogen-to-silane (H₂/SiH₄) ratio of 8 to10 and a working pressure may range from about 70 to about 90 mTorr, and processing power may range from about 200 to about 300 W, and a processing temperature may range from about 250 to about 350°C.

When the top-cell intrinsic layer 336 is formed by ICP-CVD, noticeable improvement is attained in an interfacial characteristic between the top-cell intrinsic layer 336 and a layer contacting the top-cell intrinsic layer 336, particularly the first-type silicon nano wire layer 334.

The top-cell intrinsic layer 336 may have a thickness in a range of about 400 to about 600 nm, preferably about 500 nm.

The top-cell second-type doping layer 338 is provided on the top-cell intrinsic layer 336.

The top-cell second-type doping layer 338 may be a second type doped Si layer.

Here, the top-cell second-type doping layer 338 may have the same configuration as that labeled 260 shown in FIG. 2.

The top-cell second-type doping layer 338 may be a second+-type doping layer or a second-type doping layer, which is a layer with a lower impurity level.

The top-cell second-type doping layer 338 may be formed by PVD or CVD, such as PECVD.

The buffer layer 340 is provided on the top-cell second-type doping layer 338.

The buffer layer 340 electrically connects the top cell 330 to the bottom cell 350.

The buffer layer 340 functions to electrically connect the top cell 330 to the bottom cell 350, particularly the top-cell second-type doping layer 338 of the top cell 330 to the bottom-cell first-type doping layer 352 of the bottom cell 350 to establish tunnel junction.

The buffer layer 340 also adjusts the bandgap between the top cell 330 and the bottom cell 350.

The buffer layer 340 may be made of a transparent conduct material such as ZnO.

The bottom-cell first-type doping layer 352 is formed on the buffer layer 340.

The bottom-cell first-type doping layer 352 may be a first+-type doping layer or a first-type doping layer, which is a layer with a lower impurity level. Alternatively, the bottom-cell first-type doping layer 352 may be a second-type doping layer with a lower impurity level than the first+-type doping layer.

The bottom-cell first-type doping layer 352 may be formed by PVD or CVD.

The bottom-cell intrinsic layer 354 may be formed on the bottom-cell first-type doping layer 352.

The bottom-cell intrinsic layer 354 may be made of intrinsic silicon undoped with first- or second-type impurity.

The bottom-cell intrinsic layer 354 may be made of a variety of intrinsic silicon layers, preferably, a hydrogenated microcrystallized layer, that is, an I µc-Si:H layer.

The bottom-cell intrinsic layer 354 may be formed by chemical vapor deposition or physical vapor deposition.

The bottom-cell intrinsic layer 354 may have a thickness of about 1 to about 2 *µ*m.

The bottom-cell second-type doping layer 356 is provided on the bottom-cell intrinsic layer 354.

The bottom-cell second-type doping layer 356 may be a second type doped Si layer.

The bottom-cell second-type doping layer 356 may be a second+-type doping layer or a second-type doping layer, which is a layer with a lower impurity level.

The bottom-cell second-type doping layer 356 may be formed by PVD or CVD, such as PECVD.

The rear electrode 360 may be provided on the bottom-cell second-type doping layer 356.

The rear electrode 360 may be made of a conductive material such as Al or Ag.

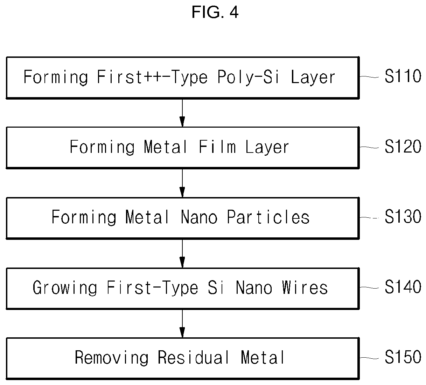

FIG. 4 is a flowchart illustrating a method for fabricating a first-type silicon nano wire according to an embodiment of the present invention.

Referring to FIG. 4, the method for fabricating a first-type silicon nano wire according to an embodiment of the present invention may include forming a first++-type poly-Si layer (S110), forming a metal film layer (S120), forming metal nano particles (S130), growing first-type Si nano wires (S140), and removing residual metals (S150).

In S110, a first++-type poly-Si layer is formed on a substrate.

The first++-type poly-Si layer is a highly doped poly-Si layer of first type.

In S110, the first++-type poly-Si layer may be formed in various techniques.

In the following, the present embodiment is described will be described using one of known techniques for forming the first++-type poly-Si layer.

The first++-type poly-Si layer may be formed such that a first++-type a-Si layer first formed on the substrate and the first++-type poly-Si layer is then formed into the first++-type poly-Si layer using a metal induced crystallization method or a laser crystallization method.

Here, the first++-type α-Si layer may be formed on the substrate 110 by a common technique, such as using a PECVD or ICP-CVD device.

Thereafter, a metal film layer is formed on the first++-type poly-Si layer in S120.

In S120, the metal film layer is formed by depositing, for example, sputtering or evaporating, a metal on the first++-type poly-Si layer.

Here, the metal film layer is deposited to a thickness of 100 to 150 nm.

In S120, the depositing of the metal film layer may include depositing the metal film layer at a low deposition rate. This is for allowing the metal film layer to be easily changed into nano particles.

At least one selected from the group consisting of Au, In, Ga and Sn may be used.

Next, metal nano particles are formed in S130.

In S130, the metal film layer is changed into nano particles. Here, the metal nano particles are formed from the metal film layer using inductively coupled plasma chemical vapor deposition or very high frequency-chemical vapor deposition.

In S130, when the metal film layer is formed using inductively coupled plasma chemical vapor deposition, the metal film layer may be formed under processing conditions including a substrate temperature from about 200 to about 400°C, a working pressure ranging from about 80 to about 150 mTorr, a hydrogen (H₂) gas flow rate ranging from about 100 to about 300 sccm, plasma power ranging from about 500 to about 700 W, susceptor power ranging from about 30 to about 50 W, and a processing time ranging from about 30 to about 90 minutes.

When the metal film layer is formed using very high frequency-chemical vapor deposition under processing conditions including a substrate temperature from about 200 to about 400°C, a working pressure ranging from about 0.05 to about 0.02 Torr, plasma power ranging from about 40 to about 60 W, and a processing time ranging from about 30 to about 60 minutes.

Following S130, the first-type Si nano wires are allowed to grow in S140.

In S140, the first-type Si nano wires are allowed to grow using inductively coupled plasma chemical vapor deposition or very high frequency-chemical vapor deposition.

In detail, S140 is an operation of allowing the first-type Si nano wires to grow on the first++-type poly-Si layer using the metal nano particles as seeds.

That is to say, the metal nano particles serve as seeds for growth of the metal nano particles formed on the first++-type poly-Si layer, and the first-type Si nano wires grow from the first++-type poly-Si layer.

In S140, in case of using inductively coupled plasma chemical vapor deposition, the first-type Si nano wires are allowed to grow under processing conditions including a substrate temperature from about 200 to about 400°C, a working pressure ranging from about 70 to about 80 mTorr, a silane (SiH₄) gas ratio of 0.1 to 0.2, plasma power ranging from about 500 to about 700 W, susceptor power ranging from about 30 to about 50 W, and a processing time ranging from about 1 to about 20 minutes. Here, the silane gas ratio may correspond to a ratio of silane gas relative to the mixed gas containing silane and hydrogen gases.

Alternatively, in S140, in case of using very high frequency-chemical vapor deposition, the first-type Si nano wires are allowed to grow under processing conditions including a substrate temperature from about 200 to about 400°C, a working pressure ranging from about 0.05 to about 0.02 Torr, a silane (SiH₄) gas ratio of 0.4 to 0.6, plasma power ranging from about 40 to about 60 W, and a processing time ranging from about 30 to about 60 minutes.

S130 and S140 may be continuously performed using inductively coupled plasma chemical vapor deposition or very high frequency-chemical vapor deposition. That is to say, changing the metal film layer formed on the first++-type poly-Si layer into metal nano particles and the growing the first-type Si nano wires using the metal nano particles can be continuously performed using inductively coupled plasma chemical vapor deposition or very high frequency-chemical vapor deposition.

Here, the silicon nano wire may have a length in a range of about 2 to about 5 µm and a diameter in a range of about 1 to about 5 nm.

Following S140, residual metals are removed from the substrate in S150.

In S150, the residual metals on the substrate, particularly, on the first-type silicon nano wire layer including the first-type silicon nano wires, are removed using a wet process, such as etching.

The residual metals may include part of the metal film layer or the metal nano particles.

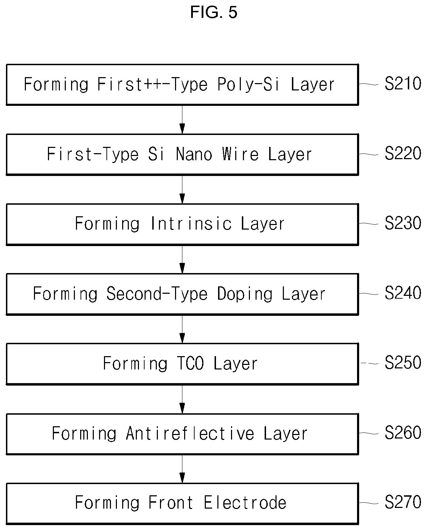

FIG. 5 is a flowchart illustrating a sequential process of a method for fabricating a solar cell according to an embodiment of the present invention.

Referring to FIG. 5, the method for fabricating a solar cell according to an embodiment of the present invention may include forming a first++-type poly-Si layer (S210), forming a forming a first-type Si nano wire layer (S220), forming an intrinsic layer (S230), forming a second-type doping layer (S240), forming a TCO layer (S250), forming an antireflective layer (S260), and forming a front electrode (S270).

Here, the method for fabricating a solar cell according to this embodiment of the present invention will be described with regard to the solar cell illustrated in FIG. 1.

In S210, a first++-type poly-Si layer 120 is formed on the substrate 110.

Prior to formation of the first++-type poly-Si layer 120, the substrate 110 is first washed. The substrate 110 is washed to remove organic matter, metals, oxide or the like remaining on the substrate 110. The removing of the organic matter or the like may be performed using a generally known technique in the semiconductor manufacturing process.

Next, the first++-type poly-Si layer 120 is formed on the substrate 110.

The forming of the first++-type poly-Si layer 120 may be performed in the same manner as in S110, and a detailed explanation will not be made.

Thereafter, the first-type Si nano wire layer 130 is formed in S220.

S220 is an operation of forming the first-type Si nano wire layer 130 by allowing the first-type Si nano wires to grow.

In S220, the first-type Si nano wires are allowed to grow by sequentially performing S120, S130, S140 and S150, which have been described in FIG. 4, thereby forming the first++-type poly-Si layer 130 from the first++-type poly-Si layer 120. Thus, a detailed explanation will not be made.

Next, the intrinsic layer 140 is formed in S230.

In S230, the intrinsic layer 140 is formed on the first-type silicon nano wire layer 130 and on a surface of the first++-type poly-Si layer 120 without first-type silicon nano wires grown thereon.

In S230, the intrinsic layer 140 may be formed of intrinsic silicon undoped with first- or second-type impurity. That is, the intrinsic layer 140 may be made of a variety of intrinsic silicon layers, preferably, a hydrogenated amorphous silicon layer, that is, an α-Si:H layer.

In S230, the intrinsic layer 140 may be formed by chemical vapor deposition or physical vapor deposition.

When the intrinsic layer 140 is formed by ICP-CVD, mixed gas containing hydrogen (H₂) gas and silane (SiH₄) gas may be used. In this case, the intrinsic layer 140 may be formed under the processing conditions including a hydrogen-to-silane (H₂/SiH₄) ratio of 8 to10 and a working pressure ranging from about 70 to about 90 mTorr, processing power ranging from about 200 to about 300 W, and a processing temperature ranging from about 250 to about 350°C.

Following S230, the second-type doping layer is formed on the intrinsic layer in S240.

In S240, the second-type doping layer 150, that is, the second-type impurity layer or the second+-type Si layer, may be formed by chemical vapor deposition or physical vapor deposition.

Next, the TCO layer 160 is formed on the second-type doping layer 150 in S250.

In detail, in S250, the TCO layer 160 is formed on the second-type doping layer 150.

In S250, the TCO layer 160 is formed using TCO (Transparent Conducting Oxide) such as ZnO (Zinc Oxide), AZO (Aluminum Zinc Oxide), ITO (Indium Tin Oxide), SnO₂:F, and so on to a thickness of 5 *µ*m or greater.

S250 may be an operation of forming the TCO layer 160 using PVD such as sputtering or CVD such as MOCVD.

Following S250, the antireflective layer 170 is formed in S260.

In detail, in S260, the antireflective layer 170 is formed on the TCO layer 160 using silicon nitride (SiN).

In SS250, the antireflective layer 170 may be formed by two methods.

First, the antireflective layer 170 may be formed on an entire surface of the TCO layer 160. Second, the antireflective layer 170 is formed on an entire surface of the TCO layer 160 in patterned formats so as to expose predetermined regions of the TCO layer 160.

Next, the front electrode is formed in S270.

In S270, the front electrode 180 is formed to contact the TCO layer 160 on the predetermined regions of the TCO layer 160 exposed by the antireflective layer 170.

The forming of the front electrode 180 may be performed in two manners.

First, when the antireflective layer 170 is formed on an entire surface of the TCO layer 160, paste for forming the front electrode 180 is coated on a predetermined area of the antireflective layer 170 in patterned formats and sintered. Then, the resulting antireflective layer 170 is etched to form the front electrode 180 contacting the TCO layer 160.

Here, the past for forming the front electrode 180 may contain Al or Ag forming the front electrode 180 and etchant capable of etching away the antireflective layer 170.

Second, when the antireflective layer 170 is formed on the TCO layer 160 in patterned formats, on an entire surface of the TCO layer 160, the front electrode 180 may be deposited in a manner in which it is patterned on the exposed TCO layer 160. That is to say, the front electrode 180 may be patterned using a pattern mask.

In S270, the front electrode 180 may be formed to a thickness of about 0.2 to about 1 µm, preferably about 0.5 µm.

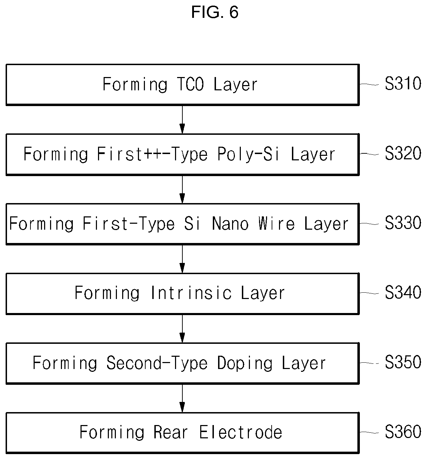

FIG. 6 is a flowchart illustrating a sequential process of a method for fabricating a solar cell according to another embodiment of the present invention.

Referring to FIG. 6, the method for fabricating a solar cell according to another embodiment of the present invention may include forming a TCO layer (S310), a first++-type poly-Si layer (S320), forming a first-type Si nano wire layer (S330), forming an intrinsic layer (S340), forming a second-type doping layer (S350), and forming a rear electrode (S270).

Here, the method for fabricating a solar cell according to this embodiment of the present invention will be described with regard to the solar cell 200 illustrated in FIG. 2.

In S310, the TCO layer 220 is formed on the substrate 210.

Prior to formation of the TCO layer 220, the substrate 210 is first washed. The washing of the substrate 210 may be performed in the same manner as described with reference to FIG. 5, and a detailed explanation thereof will not be given.

In addition, the forming of the TCO layer 220 is also performed in the same manner as in S250 described with reference to FIG. 5, and a detailed explanation thereof will not be given.

Thereafter, the first++-type poly-Si layer 230 is formed in S320.

S320 is an operation of forming the first++-type poly-Si layer 230 on the TCO layer 220, which may be performed in the same manner as described with reference to FIG. 5, and a detailed explanation thereof will not be given.

Following S320, the first-type Si nano wire layer is formed in S330.

Next, the intrinsic layer 250 is formed in S340.

In S340, the intrinsic layer 250 is formed on the surface having the first++-type poly-Si layer 240 grown thereon to a thickness of 400 to 600 nm, preferably, 500 nm. The operations S230 and S340 of forming the intrinsic layers are substantially the same with each other except for the layer thickness, and a detailed explanation thereabout will not be given.

Next, the second-type doping layer 260 is formed on the intrinsic layer 250 in S350.

In S350, the second-type doping layer 260 is formed to a thickness of 10 to 15 µm, preferably about 15 µm. The operations S240 and S350 of forming the second-type doping layers are substantially the same with each other except for the layer thickness, and a detailed explanation thereabout will not be given.

Next, the rear electrode is formed in S360.

In detail, in S360, the rear electrode 270 is formed on the second-type doping layer 260.

In S360, when the rear electrode 270 is formed of Al, it may have a thickness of 200 to 400 nm, preferably 300.

S360 is an operation of forming the rear electrode 270 made of a conductive material, such as Al or Ag, on the second-type doping layer 260.

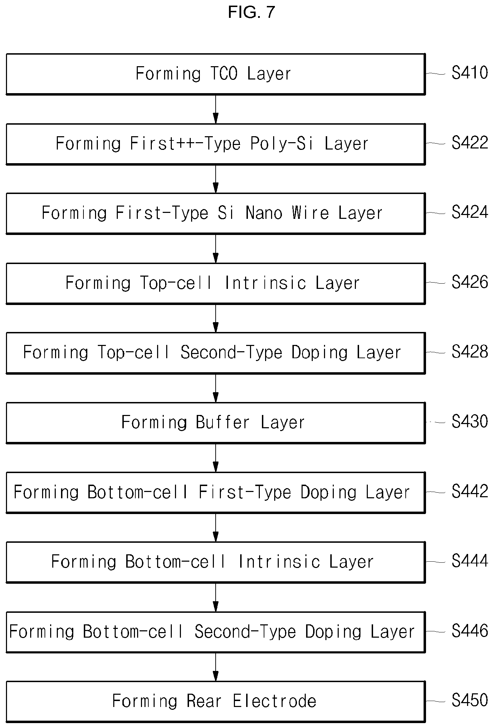

FIG. 7 is a flowchart illustrating a sequential process of a method for fabricating a solar cell according to still another embodiment of the present invention.

Referring to FIG. 7, the method for fabricating a solar cell according to still another embodiment of the present invention may include forming a TCO layer (S410), forming a first++-type poly-Si layer (S422), forming a first-type Si nano wire layer (S424), forming a top-cell intrinsic layer (S426), forming a top-cell second-type doping layer (S428), forming a buffer layer (S430), forming a bottom-cell first-type doping layer (S442), forming a bottom-cell intrinsic layer (S444), forming a bottom-cell second-type doping layer (S446), and forming a rear electrode (S450).

Here, the method for fabricating a solar cell according to this embodiment of the present invention will be described with regard to the solar cell 300 illustrated in FIG. 3.

In S410, the TCO layer is formed on the substrate 310.

Prior to formation of the first++-type poly-Si layer 120, the substrate 310 is first washed.

The washing of the substrate 310 may be performed in the same manner as described with reference to FIG. 5, and a detailed explanation thereof will not be given.

Following S410, S422, S424, S426 and S428 are sequentially performed. In detail, in S410, the first++-type poly-Si layer 332 is formed on the TCO layer 320 and the first-type silicon nano wires are allowed to grow from the first-type silicon nano wire layer 334 to form the first-type silicon nano wire layer 334. Then, the top-cell intrinsic layer 336 is formed on the substrate having the first-type silicon nano wire layer 334 and the top-cell second-type doping layer 338 is formed on the top-cell intrinsic layer 336.

Following the S428, the buffering layer is formed in S430.

S430 is an operation of forming the buffer layer 340 to establish tunnel junction between the top-cell 330 and the bottom cell 350.

In S430, the buffer layer 340 may be formed on the top-cell second-type doping layer 338 by PVD or CVD.

Following S430, the bottom-cell first++-type poly-Si layer is formed in S422.

In S422, the bottom-cell first-type doping layer 352 is formed on the buffer layer 340.

In detail, the bottom-cell first-type doping layer 352 is formed by doping a first-type Si layer on the buffer layer 340.

Here, the bottom-cell first-type doping layer 352 may be a first+-type doping layer or a first-type doping layer, which is a layer with a lower impurity level. Alternatively, the bottom-cell first-type doping layer 352 may be a second-type doping layer with a lower impurity level than the first+-type doping layer.

In S442, the bottom-cell first-type doping layer 352 may be formed by PVD or CVD.

Next, the bottom-cell intrinsic layer 354 may be formed on the bottom-cell first-type doping layer 352 in S444.

In S444, the bottom-cell intrinsic layer 354 may be directly formed using a hydrogenated microcrystallized layer, that is, an I µc-Si:H layer, to a thickness of about 1 to about 2 *µ*m.

Alternatively, the bottom-cell intrinsic layer 354 may be formed using a hydrogenated microcrystallized layer, that is, an I µc-Si:H layer by metal induced crystallization method or laser crystallization method.

Next, the bottom-cell second-type doping layer is formed in S446.

In S446, the bottom-cell second-type doping layer 356 is formed on the bottom-cell intrinsic layer 354. The bottom-cell second-type doping layer 356 may be formed in substantially the same manner as S230 described with reference to FIG. 5, and a detailed explanation thereof will not be given.

Following S446, the rear electrode is formed in S450.

In S450, the rear electrode 360 is formed on the bottom-cell second-type doping layer 356. The rear electrode 360 may be formed in substantially the same manner as described with reference to FIG. 6, and a detailed explanation thereof will not be given.

## Claims

1. A solar cell comprising:
a substrate,
a first++-type poly-Si layer formed on the substrate,
a first-type silicon nano wire layer including a first-type silicon nano wire grown from the first++-type poly-Si layer,
an intrinsic layer formed on the substrate having the first-type silicon nano wire layer, and
a second-type doping layer formed on the intrinsic layer, said second-type doping layer having an impurity level lower than the first++-type poly-Si layer,
wherein the first-type silicon nano wire has a length in a range of 2 to to 5 µm and a diameter in a range of 1 to 5 nm.

2. The solar cell of claim 1, further comprising:
- a transparent conductive oxide (TCO) layer provided on the second-type doping layer,
- an antireflective layer formed on the TCO layer to expose predetermined regions of the TCO layers, and
- a front electrodes patterned on the predetermined regions of the exposed TCO layer;
or
- a transparent conductive oxide (TCO) layer provided between the substrate and the first++-type poly-Si layer, and
- a rear electrode formed on the second-type doping layer.

3. The solar cell of claim 1, wherein the intrinsic layer is a top-cell intrinsic layer, the second-type doping layer is a top-cell second-type doping layer, and the solar cell further comprises:
a buffer layer formed on the top-cell second-type doping layer,
a bottom-cell first-type doping layer formed on the buffer layer,
a bottom-cell intrinsic layer formed on the bottom-cell first-type doping layer,
a bottom-cell second-type doping layer formed on the bottom-cell intrinsic layer, and
a rear electrode formed on the bottom-cell second-type doping layer.

4. A method for fabricating a solar cell comprising:
forming a first++-type poly-Si layer, on a substrate,
forming a metal film layer on the first++-type poly-Si layer,
forming metal nano particles from the metal film layer, and
growing first-type Si nano wires on the first++-type poly-Si layer using the metal nano particles as seeds,
wherein the first-type silicon nano wires have a length in a range of 2 to 5 *µ*m and a diameter in a range of 1 to 5 nm,
forming an intrinsic layer on the substrate having the first-type Si nano wires grown thereon,
forming a second-type doping layer on the intrinsic layer, said second-type doping layer having an impurity level lower than the first++-type poly-Si layer,
forming a TCO layer on the second-type doping layer,
forming an antireflective layer on the TCO layer, and
forming a front electrode.

5. The method of claim 4, before the forming of the first++-type poly-Si layer, further comprising:
forming a TCO layer on the substrate, and after the growing of the first-type Si nano wires, further comprising:
forming an intrinsic layer on the substrate having the first-type Si nano wires grown thereon,
forming a second-type doping layer on the intrinsic layer, and
forming a rear electrode.

6. The method of claim 4, before the forming of the first++-type poly-Si layer, further comprising:
forming a TCO layer on the substrate, and after the growing of the first-type Si nano wires, further comprising:
forming a top-cell intrinsic layer on the substrate having the first-type Si nano wires grown thereon,
forming a top-cell second-type doping layer on the top-cell intrinsic layer,
forming a buffer layer on the top-cell second-type doping layer,
forming a bottom-cell first-type doping layer on the buffer layer,
forming a bottom-cell intrinsic layer on the bottom-cell first-type doping layer,
forming a bottom-cell second-type doping layer on the bottom-cell intrinsic layer, and
forming a rear electrode.

7. The method of claim 4, wherein the forming of the metal film layer comprises forming the metal film layer using a sputtering method or evaporation method to a thickness in a range of about 100 to about 150 nm, and wherein in the forming of the metal film layer, at least one selected from the group consisting of Au, In, Ga and Sn is preferably used.

8. The method of claim 4 wherein in the forming of the metal film layer or the growing of the first-type Si nano wires, inductively coupled plasma chemical vapor deposition or very high frequency-chemical vapor deposition is used, and wherein, preferably:
- the forming of the metal film layer and the growing of the first-type Si nano wires are performed in sequence using inductively coupled plasma chemical vapor deposition or very high frequency-chemical vapor deposition; or
- the forming of the metal film layer comprises forming the metal film layer from metal nano particles using inductively coupled plasma chemical vapor deposition under processing conditions including a substrate temperature from about 200 to about 400°C, a working pressure ranging from about 10.64 Pa (80 mTorr) to about 19.95 Pa (150 mTorr), a hydrogen (H₂) gas flow rate ranging from about 100 to about 300 sccm, plasma power ranging from about 500 to about 700 W, susceptor power ranging from about 30 to about 50 W, and a processing time ranging from about 30 to about 90 minutes; or
- the forming of the metal film layer comprises forming the metal film layer from metal nano particles using very high frequency-chemical vapor deposition under processing conditions including a substrate temperature from about 200 to about 400°C, a working pressure ranging from about 6.65 Pa (0.05 Torr) to about 2.66 Pa (0.02 Torr), plasma power ranging from about 40 to about 60 W, and a processing time ranging from about 30 to about 60 minutes; or
- the growing of the first-type Si nano wires comprises allowing the first-type Si nano wires to grow using inductively coupled plasma chemical vapor deposition under processing conditions including a substrate temperature from about 200 to about 400°C, a working pressure ranging from about 9.31 Pa (70 mTorr) to about 10.64 Pa (80 mTorr), a silane (SiH₄) gas ratio of 0.1 to 0.2, plasma power ranging from about 500 to about 700 W, susceptor power ranging from about 30 to about 50 W, and a processing time ranging from about 1 to about 20 minutes, wherein the silane gas ratio corresponds a ratio of silane gas relative to the mixed gas containing silane and hydrogen gases; or
- the growing of the first-type Si nano wires comprises allowing the first-type Si nano wires to grow using very high frequency-chemical vapor deposition under processing conditions including a substrate temperature from about 200 to about 400°C, a working pressure ranging from about 6.65 Pa (0.05 Torr) to about 2.66 Pa (0.02 Torr), a silane (SiH₄) gas ratio of 0.4 to 0.6, plasma power ranging from about 40 to about 60 W, and a processing time ranging from about 30 to about 60 minutes.

9. The method of claim 4, further comprising removing residual metals from the substrate after the growing of the first-type Si nano wires.

## Patentansprüche

1. Solarzelle, umfassend:
ein Substrat,
eine erste ++-Poly-Si-Schicht, die auf dem Substrat gebildet ist,
eine Siliziumnanodrahtschicht ersten Typs, die einen Siliziumnanodraht ersten Typs umfasst, der von der ersten ++-Poly-Si-Schicht gewachsen ist,
eine intrinsische Schicht, die auf dem Substrat gebildet ist und die Siliziumnanodrahtschicht ersten Typs aufweist, und
eine Dotierschicht zweiten Typs, die auf der intrinsischen Schicht gebildet ist, wobei die Dotierschicht zweiten Typs ein Störstellenniveau von niedriger als der ersten ++-Poly-Si-Schicht aufweist,
wobei der Siliziumnanodraht ersten Typs eine Länge in einem Bereich von 2 bis 5 µm und einen Durchmesser in einem Bereich von 1 bis 5 nm aufweist.

2. Solarzelle nach Anspruch 1, ferner umfassend:
- eine transparente leitfähige Oxid- (TCO) -Schicht, die auf der Dotierschicht zweiten Typs vorgesehen ist,
- eine auf der TCO-Schicht gebildete Antireflexionsschicht, um vorbestimmte Regionen der TCO-Schichten freizulegen, und
- Frontelektroden, die auf den vorbestimmten Regionen der freigelegten TCO-Schicht strukturiert sind;
oder
- eine transparente leitfähige Oxid- (TCO) -Schicht, die zwischen dem Substrat und der ersten ++-Poly-Si-Schicht vorgesehen ist, und
- eine auf der Dotierschicht zweiten Typs gebildete hintere Elektrode.

3. Solarzelle nach Anspruch 1, wobei die intrinsische Schicht eine intrinsische Topzellenschicht ist, die Dotierschicht zweiten Typs eine Topzellendotierschicht zweiten Typs ist und die Solarzelle ferner umfasst:
eine auf der Topzellendotierschicht zweiten Typs gebildete Pufferschicht,
eine auf der Pufferschicht gebildete Bottomzellendotierschicht ersten Typs,
eine auf der Bottomzellendotierschicht ersten Typs gebildete intrinsische Bottomzellenschicht,
eine Bottomzellendotierschicht zweiten Typs, die auf der intrinsischen Bottomzellenschicht gebildet ist, und
eine auf der Bottomzellendotierschicht zweiten Typs gebildete hintere Elektrode.

4. Verfahren zum Herstellen einer Solarzelle, umfassend:
Bilden einer ersten ++-Poly-Si-Schicht auf einem Substrat,
Bilden einer Metallfilmschicht auf der ersten ++-Poly-Si-Schicht,
Bilden von Metallnanopartikeln von der Metallfilmschicht, und
Wachsen der Si-Nanodrähte ersten Typs auf der ersten ++-Poly-Si-Schicht unter Verwendung der Metallnanopartikel als Keime,
wobei die Siliziumnanodrähte ersten Typs eine Länge in einem Bereich von 2 bis 5 µm und einen Durchmesser in einem Bereich von 1 bis 5 nm aufweisen,
Bilden einer intrinsischen Schicht auf dem Substrat, auf dem die Si-Nanodrähte ersten Typs gewachsen sind,
Bilden einer Dotierschicht zweiten Typs auf der intrinsischen Schicht, wobei die Dotierschicht zweiten Typs ein Störstellenniveau von niedriger als die erste ++-Poly-Si-Schicht aufweist,
Bilden einer TCO-Schicht auf der Dotierschicht zweiten Typs,
Bilden einer Antireflexionsschicht auf der TCO-Schicht, und
Bilden einer vorderen Elektrode.

5. Verfahren nach Anspruch 4, das vor dem Bilden der ersten ++-Poly-Si-Schicht ferner umfasst:
Bilden einer TCO-Schicht auf dem Substrat und nach dem Wachsen der Si-Nanodrähte ersten Typs ferner umfassend:
Bilden einer intrinsischen Schicht auf dem Substrat auf dem die Si Nanodrähte ersten Typs gewachsen sind,
Bilden einer Dotierschicht zweiten Typs auf der intrinsischen Schicht, und
Bilden einer hinteren Elektrode.

6. Verfahren nach Anspruch 4, das vor dem Bilden der ersten ++-Poly-Si-Schicht ferner umfasst:
Bilden einer TCO-Schicht auf dem Substrat und nach dem Wachsen der Si-Nanodrähte ersten Typs ferner umfassend:
Bilden einer intrinsischen Topzellenschicht auf dem Substrat, auf dem die Si-Nanodrähte ersten Typs gewachsen sind,
Bilden einer Topzellendotierschicht zweiten Typs auf der intrinsischen Topzellenschicht,
Bilden einer Pufferschicht auf der Topzellendotierschicht zweiten Typs,
Bilden einer Bottomzellendotierschicht ersten Typs auf der Pufferschicht,
Bilden einer intrinsischen Bottomzellenschicht auf der Bottomzellendotierschicht ersten Typs,
Bilden einer Bottomzellendotierschicht zweiten Typs auf der intrinsischen Bottomzellenschicht, und
Bilden einer hinteren Elektrode.

7. Verfahren nach Anspruch 4, wobei das Bilden der Metallfilmschicht das Bilden der Metallfilmschicht unter Verwendung eines Sputterverfahrens oder Aufdampfverfahrens zu einer Dicke in einem Bereich von ungefähr 100 bis zu ungefähr 150 nm umfasst, und wobei beim Bilden der Metallfilmschicht mindestens eines bevorzugt verwendet wird, das ausgewählt ist aus der Gruppe bestehend aus Au, In, Ga und Sn.

8. Verfahren nach Anspruch 4, wobei beim Bilden der Metallfilmschicht oder dem Wachsen der Si-Nanodrähte ersten Typs induktiv gekoppelte chemische Plasmagasphasenabscheidung oder chemische Gasphasenabscheidung mit sehr hoher Frequenz verwendet wird, und wobei bevorzugt:
- das Bilden der Metallfilmschicht und das Wachsen der ersten Si-Nanodrähte ersten Typs der Reihe nach unter Verwendung von induktiv gekoppelter chemischer Plasmagasphasenabscheidung oder chemische Gasphasenabscheidung mit sehr hoher Frequenz ausgeführt werden; oder
- das Bilden der Metallfilmschicht das Bilden der Metallfilmschicht aus Metallnanopartikel unter Verwendung von induktiv gekoppelter chemischer Plasmagasphasenabscheidung unter Verarbeitungsbedingungen einschließlich einer Substrattemperatur von ungefähr 200 bis zu ungefähr 400 °C, einem Arbeitsdruck im Bereich von ungefähr 10,64 Pa (80 mTorr) bis zu ungefähr 19,95 Pa (150 mTorr), einem Wasserstoff-(H₂) -Gasdurchfluss im Bereich von ungefähr 100 bis zu ungefähr 300 sccm, einer Plasmaleistung im Bereich von ungefähr 500 bis zu ungefähr 700 W, einer Suszeptorleistung im Bereich von ungefähr 30 bis zu ungefähr 50 W und einer Verarbeitungszeit im Bereich von ungefähr 30 bis zu ungefähr 90 Minuten umfasst; oder
- das Bilden der Metallfilmschicht das Bilden der Metallfilmschicht aus Metallnanopartikel unter Verwendung von chemischer Gasphasenabscheidung mit sehr hoher Frequenz unter Verarbeitungsbedingungen einschließlich einer Substrattemperatur von ungefähr 200 bis zu ungefähr 400 °C, einem Arbeitsdruck im Bereich von ungefähr 6,65 Pa (0,05 Torr) bis zu ungefähr 2,66 Pa (0,02 Torr), einer Plasmaleistung im Bereich von ungefähr 40 bis zu ungefähr 60 W und einer Verarbeitungszeit im Bereich von ungefähr 30 bis zu ungefähr 60 Minuten umfasst; oder
- das Wachsen der Si-Nanodrähte ersten Typs das Erlauben umfasst, dass die Si-Nanodrähte ersten Typs unter Verwendung von induktiv gekoppelter chemischer Plasmagasphasenabscheidung unter Verarbeitungsbedingungen einschließlich einer Substrattemperatur von ungefähr 200 bis zu ungefähr 400 °C, einem Arbeitsdruck im Bereich von ungefähr 9,31 Pa (70 mTorr) bis zu ungefähr 10,64 Pa (80 mTorr), einem Silan- (SiH₄) -Gas-Verhältnis von 0,1 bis 0,2, einer Plasmaleistung im Bereich von ungefähr 500 bis zu ungefähr 700 W, einer Suszeptorleistung im Bereich von ungefähr 30 bis zu ungefähr 50 W und einer Verarbeitungszeit im Bereich von ungefähr 1 bis zu ungefähr 20 Minuten wachsen, wobei das Silan-Gas-Verhältnis einem Verhältnis von Silangas relativ zu dem Mischgas, das Silan und Wasserstoffgase enthält, entspricht; oder
- das Wachsen der Si-Nanodrähte ersten Typs das Erlauben umfasst, dass die Si-Nanodrähte unter Verwendung von chemischer Gasphasenabscheidung mit sehr hoher Frequenz unter Verarbeitungsbedingungen einschließlich einer Substrattemperatur von ungefähr 200 bis zu ungefähr 400 °C, einem Arbeitsdruck im Bereich von ungefähr 6,65 Pa (0,05 Torr) bis zu ungefähr 2,66 Pa (0,02 Torr), einem Silan- (SiH₄) -Gas-Verhältnis von 0,4 bis 0,6, einer Plasmaleistung im Bereich von ungefähr 40 bis zu ungefähr 60 W und einer Verarbeitungszeit im Bereich von ungefähr 30 bis zu ungefähr 60 Minuten wachsen.

9. Verfahren nach Anspruch 4, ferner umfassend das Entfernen von Restmetallen von dem Substrat nach dem Wachsen der Si-Nanodrähte ersten Typs.

## Revendications

1. Cellule solaire comprenant :
un substrat,
une couche de silicium polycristallin de premier type ++ formée sur le substrat,
une couche de nano fil de silicium de premier type comprenant un nano fil de silicium de premier type développé à partir de la couche de silicium polycristallin de premier type ++,
une couche intrinsèque formée sur le substrat comportant la couche de nano fil de silicium de premier type, et
une couche de dopage de deuxième type formée sur la couche intrinsèque, ladite couche de dopage de deuxième type ayant un niveau d'impureté inférieur à celui de la couche de silicium polycristallin de premier type ++,
dans laquelle le nano fil de silicium de premier type a une longueur dans une plage de 2 à 5 µm et un diamètre dans une plage de 1 à 5 nm.

2. Cellule solaire selon la revendication 1, comprenant en outre :
- une couche d'oxyde conducteur transparente (TCO) prévue sur la couche de dopage de deuxième type,
- une couche antireflet formée sur la couche de TCO pour exposer des régions prédéterminées des couches de TCO, et
- une électrode avant structurée sur les régions prédéterminées de la couche de TCO exposée ;
ou
- une couche d'oxyde conducteur transparente (TCO) prévue entre le substrat et la couche de silicium polycristallin de premier type ++, et
- une électrode arrière formée sur la couche de dopage de deuxième type.

3. Cellule solaire selon la revendication 1, dans laquelle la couche intrinsèque est une couche intrinsèque de cellule supérieure, la couche de dopage de deuxième type est une couche de dopage de deuxième type de cellule supérieure, et la cellule solaire comprend en outre :
une couche tampon formée sur la couche de dopage de deuxième type de cellule supérieure,
une couche de dopage de premier type de cellule inférieure formée sur la couche tampon,
une couche intrinsèque de cellule inférieure formée sur la couche de dopage de premier type de cellule inférieure,
une couche de dopage de deuxième type de cellule inférieure formée sur la couche intrinsèque de cellule inférieure, et
une électrode arrière formée sur la couche de dopage de deuxième type de cellule inférieure.

4. Procédé pour fabriquer une cellule solaire comprenant :
la formation d'une couche de silicium polycristallin de premier type ++, sur un substrat,
la formation d'une couche de film métallique sur la couche de silicium polycristallin de premier type ++,
la formation de nano particules métalliques à partir de la couche de film métallique, et
le développement de nano fils de silicium de premier type sur la couche de silicium polycristallin de premier type ++ en utilisant les nano particules métalliques en tant que germes,
dans lequel les nano fils de silicium de premier type ont une longueur dans une plage de 2 à 5 µm et un diamètre dans une plage de 1 à 5 nm,
la formation d'une couche intrinsèque sur le substrat sur lequel les nano fils de silicium de premier type ont été développés,
la formation d'une couche de dopage de deuxième type sur la couche intrinsèque, ladite couche de dopage de deuxième type ayant un niveau d'impureté inférieur à celui de la couche de silicium polycristallin de premier type ++,
la formation d'une couche de TCO sur la couche de dopage de deuxième type,
la formation d'une couche antireflet sur la couche de TCO, et
la formation d'une électrode avant.

5. Procédé selon la revendication 4, avant la formation de la couche de silicium polycristallin de premier type ++, comprenant en outre :
la formation d'une couche de TCO sur le substrat, et après le développement des nano fils de silicium de premier type, comprenant en outre :
la formation d'une couche intrinsèque sur le substrat sur lequel les nano fils de silicium de premier type ont été développés,
la formation d'une couche de dopage de deuxième type sur la couche intrinsèque, et
la formation d'une électrode arrière.

6. Procédé selon la revendication 4, avant la formation de la couche de silicium polycristallin de premier type ++, comprenant en outre :
la formation d'une couche de TCO sur le substrat, et après le développement des nano fils de silicium de premier type, comprenant en outre :
la formation d'une couche intrinsèque de cellule supérieure sur le substrat sur lequel les nano fils de silicium de premier type ont été développés,
la formation d'une couche de dopage de deuxième type de cellule supérieure sur la couche intrinsèque de cellule supérieure,
la formation d'une couche tampon sur la couche de dopage de deuxième type de cellule supérieure,
la formation d'une couche de dopage de premier type de cellule inférieure sur la couche tampon,
la formation d'une couche intrinsèque de cellule inférieure sur la couche de dopage de premier type de cellule inférieure,
la formation d'une couche de dopage de deuxième type de cellule inférieure sur la couche intrinsèque de cellule inférieure, et
la formation d'une électrode arrière.

7. Procédé selon la revendication 4, dans lequel la formation de la couche de film métallique comprend la formation de la couche de film métallique en utilisant un procédé de pulvérisation ou un procédé d'évaporation à une épaisseur dans une plage d'environ 100 à environ 150 nm, et dans lequel, dans la formation de la couche de film métallique, au moins l'un sélectionné dans le groupe consistant en Au, In, Ga et Sn est de préférence utilisé.

8. Procédé selon la revendication 4, dans lequel, dans la formation de la couche de film métallique ou le développement des nano fils de silicium de premier type, un dépôt chimique en phase vapeur à plasma couplé inductivement ou un dépôt chimique en phase vapeur à fréquence très élevée est utilisé, et dans lequel, de préférence :
- la formation de la couche de film métallique et le développement des nano fils de silicium de premier type sont effectués séquentiellement en utilisant un dépôt chimique en phase vapeur à plasma couplé inductivement ou un dépôt chimique en phase vapeur à fréquence très élevée ; ou
- la formation de la couche de film métallique comprend la formation de la couche de film métallique à partir de nano particules métalliques en utilisant un dépôt chimique en phase vapeur à plasma couplé inductivement dans des conditions de traitement comprenant une température de substrat d'environ 200 à environ 400 °C, une pression de travail allant d'environ 10,64 Pa (80 mtorrs) à environ 19,95 Pa (150 mtorrs), un débit de gaz hydrogène (H₂) allant d'environ 100 à environ 300 sccm, une puissance de plasma allant d'environ 500 à environ 700 W, une puissance de suscepteur allant d'environ 30 à environ 50 W, et un temps de traitement allant d'environ 30 à environ 90 minutes ; ou
- la formation de la couche de film métallique comprend la formation de la couche de film métallique à partir de nano particules métalliques en utilisant un dépôt chimique en phase vapeur à fréquence très élevée dans des conditions de traitement comprenant une température de substrat d'environ 200 à environ 400 °C, une pression de travail allant d'environ 6,65 Pa (0,05 Torr) à environ 2,66 Pa (0,02 Torr), une puissance de plasma allant d'environ 40 à environ 60 W, et un temps de traitement allant d'environ 30 à environ 60 minutes ; ou
- le développement des nano fils de silicium de premier type comprend le développement des nano fils de silicium de premier type en utilisant un dépôt chimique en phase vapeur à plasma couplé inductivement dans des conditions de traitement comprenant une température de substrat d'environ 200 à environ 400 °C, une pression de travail allant d'environ 9,31 Pa (70 mtorrs) à environ 10,64 Pa (80 mtorrs), un rapport de gaz silane (SiH₄) de 0,1 à 0,2, une puissance de plasma allant d'environ 500 à environ 700 W, une puissance de suscepteur allant d'environ 30 à environ 50 W, et un temps de traitement allant d'environ 1 à environ 20 minutes, dans lequel le rapport de gaz silane correspond à un rapport de gaz silane en relation avec le gaz mélangé contenant des gaz silane et hydrogène ; ou
- le développement des nano fils de silicium de premier type comprend le développement des nano fils de silicium de premier type en utilisant un dépôt chimique en phase vapeur à fréquence très élevée dans des conditions de traitement comprenant une température de substrat d'environ 200 à environ 400 °C, une pression de travail allant d'environ 6,65 Pa (0,05 Torr) à environ 2,66 Pa (0,02 Torr), un rapport de gaz silane (SiH₄) de 0,4 à 0,6, une puissance de plasma allant d'environ 40 à environ 60 W, et un temps de traitement allant d'environ 30 à environ 60 minutes.

9. Procédé selon la revendication 4, comprenant en outre le retrait des métaux résiduels du substrat après que le développement des nano fils de silicium de premier type.
